# EUROPEAN PATENT SPECIFICATION

(11) **EP 2 369 905 B1**
(45) Date of publication and mention of the grant of the patent: **10.10.2018**
(21) Application number: 11152197.7
(22) Date of filing: 26.01.2011
(51) Int. Cl.: H05K 5/00

(54) **Housing and electronic device using same**
Gehäuse und elektronische Vorrichtung damit
Boîtier et dispositif électronique l'utilisant

(30) Priority: 26.03.2010 CN 201010133529
(43) Date of publication of application: 28.09.2011
(73) Proprietor: Shenzhen Futaihong Precision Industry Co., Ltd., Shenzhen City, Guangdong Province 518109 (CN); FIH (Hong Kong) Limited, Cheung Sha Wan Kowloon, Hong Kong (CN)
(72) Inventor: Gu, Chang-Hai, ShenZhen City Guangdong 518109 (CN); Ho, Po-Feng, Shindian (TW)
(74) Representative: CMS Cameron McKenna Nabarro Olswang LLP

(56) References cited:
- US-A1- 2008 158 798
- US-A1- 2009 079 904

## Description

### Background

### 1. Technical Field

The disclosure generally relates to housings, particularly to housings used in electronic devices.

### 2. Description of Related Art

Many housings for electronic devices include a main body and a transparent screen guard. The main body and the screen guard are manufactured in separate molding processes and glued or fixed together by some method. Over time, the fixture between the main body and the screen guard may wear and allow dust and moisture to enter the housing, potentially damaging the electronic elements inside. Furthermore, because the main body and the screen guard are made in two separate processes and then connected in a separate step, assembly time is long and complicated, making manufacturing burdensome.

Therefore, there is room for improvement within the art.

### BRIEF DESCRIPTION OF THE DRAWINGS

Many aspects of the embodiments can be better understood with reference to the following drawings. The components in the drawings are not necessarily drawn to scale, the emphasis instead being placed upon clearly illustrating the principles of the exemplary housing used in an electronic device. Moreover, in the drawings like reference numerals designate corresponding parts throughout the several views. Wherever possible, the same reference numbers are used throughout the drawings to refer to the same or like elements of an embodiment.
FIG. 1 is an isometric view of an embodiment of a housing including a main body and a screen guard.
FIG. 2 is another isometric view of the housing in FIG. 1 shown in another aspect.
FIG. 3 is a cross-sectional view of the housing in FIG. 2 along the line III-III.
FIG. 4 is a cross-sectional view of an insertion of glue into the housing in FIG. 3.

### DETAILED DESCRIPTION

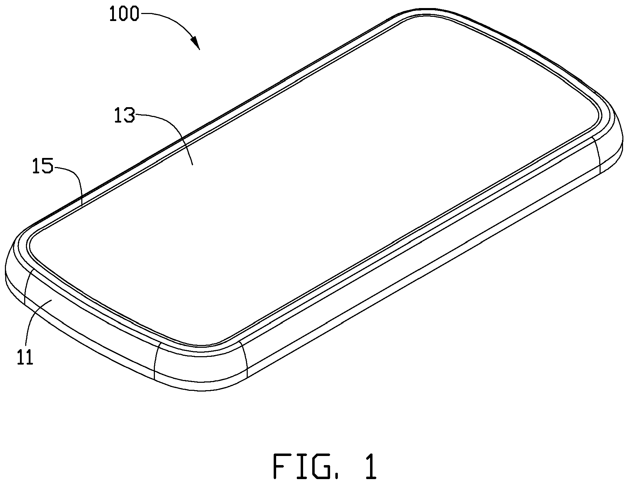

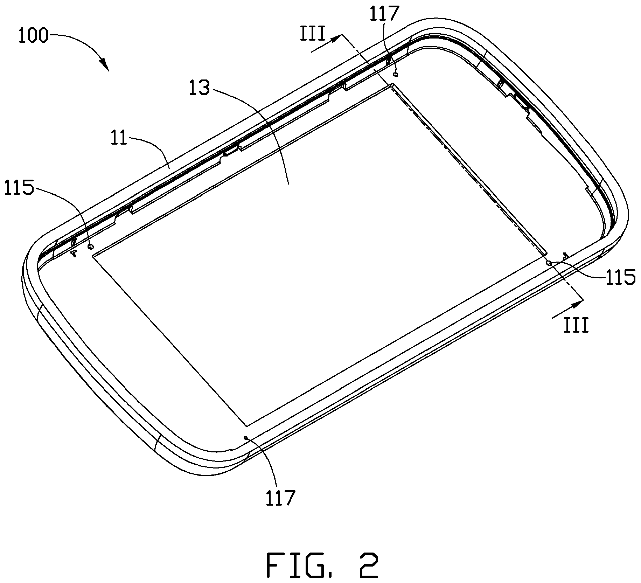

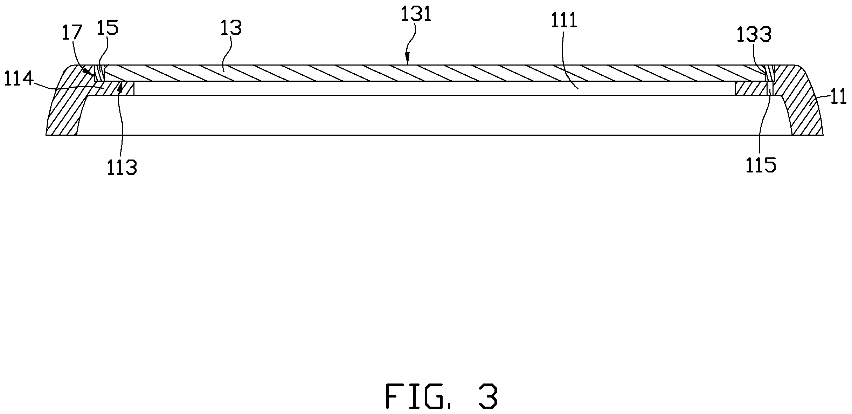

FIGS. 1 through 3 show a portion of an electronic device 100, such as a mobile phone. The electronic device 100 includes a housing (not labeled). The housing includes a main body 11, a screen guard 13 mounted to the main body 11, and a glue layer 15. The screen guard 13 is adhered to the main body 11 with glue. The glue layer 15 is formed between the screen guard 13 and the main body 11 by injecting the glue between the screen guard 13 and the main body 11. The main body 11 may be molded from a thermoplastic material that has good compact resistance and good scratch resistance, such as Polycarbonate (PC), Polymethyl Methacrylate (PMMA), Polyamide (PA), or any combination thereof.

The main body 11 defines a window 111 in an inner surface and a receiving space 113 in an outer surface for receiving the screen guard 13. The window 111 communicates with and is adjacent to the receiving space 113. The receiving space 113 is larger than the window 111, thereby forming a flange in the main body and around the window 111. The flange 114 supports the screen guard 13 when the screen guard 13 is accommodated in the receiving space 113. The flange 114 defines a number of glue injecting holes 115 and an equal number of air holes 117. In this embodiment, there are two glue injecting holes 115 and two air holes 117. The glue injecting holes 115 are respectively defined near opposite corners of the window 111 and the air holes 117 are respectively defined near the other opposite corners of the window 111. In this embodiment, each glue injecting hole 115 is substantially circular and has a diameter ranging from about 0.5 millimeter to about 1.0 millimeter, and each air hole 117 is substantially circular and has a diameter about 0.5 millimeter.

The screen guard 13 is transparent and includes an exterior surface 131 and a peripheral surface 133. When the screen guard 13 is located in the receiving space 113, a slit 17 is defined between the peripheral surface 133 and the main body 11 in the receiving space 113. The glue injecting holes 115 and the air holes 117 communicate with the slit 17 so that the glue can be injected into the slit 17. The glue layer 15 is formed by injecting the glue into the slit 17. The glue layer 15 is level with the outer surface of the housing so that the outer surface of the housing is smooth.

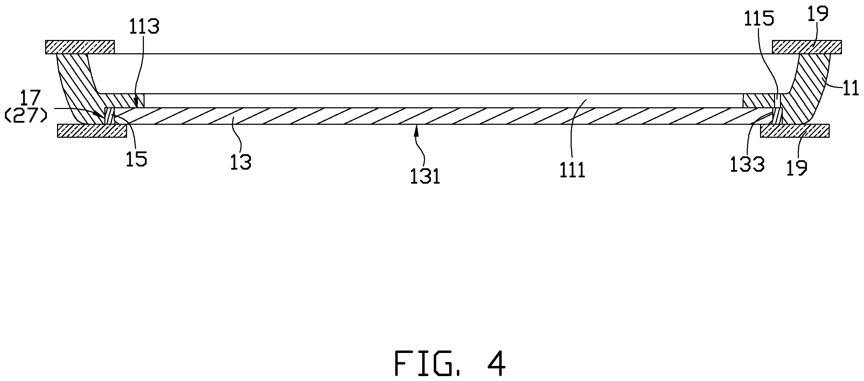

The glue layer 15 may be formed by injecting an ultraviolet curing glue into the slit 17. In this embodiment, the ultraviolet curing glue is mainly comprised of polymethyl methacrylate. Referring to FIG. 4, to inject the ultraviolet curing glue into the slit 17, the housing is held by two opposite plates 19 with one of the plates 19 positioned on the exterior surface 131 to cover the slit 17. Thus, a channel 27 is defined among the housing, the window 111 and the plate 19 positioned on the exterior surface 131. The ultraviolet curing glue is then injected into the channel 27 from the glue injecting holes 115 under twice the atmospheric pressure, until the ultraviolet curing glue flows out of the air holes 117. During this stage, the air in the channel 27 can escape from the air holes 117 to prevent pores from generating in the glue layer 15. The ultraviolet curing glue in the channel 27 is then cooled to form the glue layer 15 between the main body 11 and the screen guard 13 to adhere the screen guard 13 to the main body 11. The plate 19 positioned on the exterior surface 131 may further include transparent oil opposing the channel 27 to prevent the glue layer 15 from adhering to the one of the plates 19 positioned on the exterior surface 131.

The glue layer 15 may also be made of a hot setting glue, such as epoxy resin glue. In this case, the hot setting glue is first put in the slit 17 and then heated to form the glue layer 15 between the main body 11 and the screen guard 13 to adhere the screen guard 13 to the main body 11.

It is to be understood, however, that even through numerous characteristics and advantages of the disclosure have been set forth in the foregoing description, together with details of the system and function of the disclosure, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. A housing comprising:
a main body defining a window therein;
a screen guard covering the window to define a slit between the main body and the screen guard; and
a glue layer located in the slit to adhere the screen guard to the main body;
**characterised in that**
the main body further defines at least one glue injecting hole near the window; and
wherein the at least one glue injecting hole communicates with the window, and the glue layer is formed by injecting glue into the slit from each glue injecting hole.

2. The housing of claim 1, wherein the window is defined in an inner surface of the main body, the main body further comprises a receiving space defined in an outer surface thereof, and the screen guard is accommodated in the receiving space.

3. The housing of claim 2, wherein the window communicates with the receiving space; the receiving space is larger than the window, thereby forming a flange in the main body around the window; the flange supporting the screen guard when the screen guard is accommodated in the receiving space.

4. The housing of claim 3, wherein the at least one glue injecting hole is defined in the flange.

5. The housing of claim 4, further comprising at least one air hole defined in the flange, the at least one air hole communicating with the slit thereby allowing air to escape from the slit.

6. The housing of claim 5, wherein there are two glue injecting holes and two air holes; the glue injecting holes are respectively defined near opposite corners of the window and the air holes are respectively defined near the other opposite corners of the window.

7. The housing of claim 5, wherein the at least one glue injecting hole is substantially circular and has a diameter ranging from about 0.5 millimeter to about 1.0 millimeter.

8. The housing of claim 5, wherein the at least one air hole is substantially circular and has a diameter of about 0.5 millimeter.

9. The housing of any preceding claim, wherein the screen guard comprises an exterior surface and a peripheral surface, and the slit is defined between the peripheral surface and the main body in the receiving space.

10. The housing of claim 9, wherein the glue layer is level with the outer surface of the housing such that the outer surface of the housing is smooth.

11. The housing of any preceding claim, wherein the glue is an ultraviolet curing glue or a hot setting glue.

12. An electronic device, comprising:
a housing according to claim 1.

13. The electronic device of claim 12, wherein the window is defined in an inner surface of the main body, the main body further comprises a receiving space defined in an outer surface thereof, and the screen guard is accommodated in the receiving space.

14. The electronic device of claim 13, wherein the window communicates with the receiving space, and the receiving space is larger than the window, thereby forming a flange in the main body around the window; the flange supporting the screen guard when the screen guard is accommodated in the receiving space.

15. The electronic device of claim 14, wherein the at least one glue injecting hole is defined in the flange.

16. The electronic device of claim 15, further comprising at least one air hole defined in the flange, the at least one air hole communicating with the slit thereby allowing air to escape from the slit.

17. The electronic device of claim 16, wherein there are two glue injecting holes and two air holes; the glue injecting holes are respectively defined near opposite corners of the window and the air holes are respectively defined near the other opposite corners of the window.

18. The electronic device of claim 16, wherein the at least one glue injecting hole is substantially circular and has a diameter ranging from about 0.5 millimeter to about 1.0 millimeter

19. The electronic device of claim 16, wherein the at least one air hole is substantially circular and has a diameter of about 0.5 millimeter.

20. The electronic device of any of claims 12 to 19, wherein the screen guard comprises an exterior surface and a peripheral surface, and the slit is defined between the peripheral surface and the main body in the receiving space.

## Patentansprüche

1. Gehäuse, umfassend:
einen Hauptkörper, der ein Fenster darin definiert;
einen Schutzgitter, das das Fenster bedeckt, um einen Schlitz zwischen dem Hauptkörper und dem Schutzgitter zu definieren; und
eine Klebstoffschicht, die sich in dem Schlitz befindet, um das Schutzgitter an dem Hauptkörper festzukleben;
**dadurch gekennzeichnet, dass**
der Hauptkörper weiter zumindest ein Klebstoffeinspritzloch in der Nähe des Fensters definiert; und
wobei das zumindest eine Klebstoffeinspritzloch mit dem Fenster in Verbindung steht und die Klebstoffschicht durch Einspritzen von Klebstoff in den Schlitz von jedem Klebstoffeinspritzloch gebildet ist.

2. Gehäuse nach Anspruch 1, wobei das Fenster in einer Innenfläche des Hauptkörpers definiert ist, wobei der Hauptkörper weiter einen Aufnahmeraum umfasst, der in einer Außenfläche davon definiert ist, und das Schutzgitter in dem Aufnahmeraum untergebracht ist.

3. Gehäuse nach Anspruch 2, wobei das Fenster mit dem Aufnahmeraum in Verbindung steht; wobei der Aufnahmeraum größer als das Fenster ist, wodurch ein Flansch in dem Hauptkörper um das Fenster herum gebildet wird; wobei der Flansch das Schutzgitter trägt, wenn das Schutzgitter in dem Aufnahmeraum untergebracht ist.

4. Gehäuse nach Anspruch 3, wobei das zumindest eine Klebstoffeinspritzloch in dem Flansch definiert ist.

5. Gehäuse nach Anspruch 4, weiter umfassend zumindest ein Luftloch, das in dem Flansch definiert ist, wobei das zumindest eine Luftloch mit dem Schlitz in Verbindung steht, wodurch ermöglicht wird, dass Luft aus dem Schlitz entweicht.

6. Gehäuse nach Anspruch 5, wobei zwei Klebstoffeinspritzlöcher und zwei Luftlöcher vorhanden sind; wobei die Klebstoffeinspritzlöcher jeweils in der Nähe von gegenüberliegenden Ecken des Fensters definiert sind und die Luftlöcher jeweils in der Nähe von den anderen gegenüberliegenden Ecken des Fensters definiert sind.

7. Gehäuse nach Anspruch 5, wobei das zumindest eine Klebstoffeinspritzloch im Wesentlichen kreisförmig ist und einen Durchmesser in dem Bereich von etwa 0,5 Millimeter bis etwa 1,0 Millimeter aufweist.

8. Gehäuse nach Anspruch 5, wobei das zumindest eine Luftloch im Wesentlichen kreisförmig ist und einen Durchmesser von etwa 0,5 Millimeter aufweist.

9. Gehäuse nach einem vorstehenden Anspruch, wobei das Schutzgitter eine äußere Oberfläche und eine periphere Oberfläche umfasst und der Schlitz zwischen der peripheren Oberfläche und dem Hauptkörper in dem Aufnahmeraum definiert ist.

10. Gehäuse nach Anspruch 9, wobei die Klebstoffschicht auf einer Höhe mit der Außenfläche des Gehäuses ist, sodass die Außenfläche des Gehäuses glatt ist.

11. Gehäuse nach einem vorstehenden Anspruch, wobei der Klebstoff ein UV-härtender Klebstoff oder ein heißhärtender Klebstoff ist.

12. Elektronische Vorrichtung, umfassend:
ein Gehäuse nach Anspruch 1.

13. Elektronische Vorrichtung nach Anspruch 12, wobei das Fenster in einer Innenfläche des Hauptkörpers definiert ist, wobei der Hauptkörper weiter einen Aufnahmeraum umfasst, der in einer Außenfläche davon definiert ist, und das Schutzgitter in dem Aufnahmeraum untergebracht ist.

14. Elektronische Vorrichtung nach Anspruch 13, wobei das Fenster mit dem Aufnahmeraum in Verbindung steht und der Aufnahmeraum größer als das Fenster ist, wodurch ein Flansch in dem Hauptkörper um das Fenster herum gebildet wird; wobei der Flansch das Schutzgitter trägt, wenn das Schutzgitter in dem Aufnahmeraum untergebracht ist.

15. Elektronische Vorrichtung nach Anspruch 14, wobei das zumindest eine Klebstoffeinspritzloch in dem Flansch definiert ist.

16. Elektronische Vorrichtung nach Anspruch 15, weiter umfassend zumindest ein Luftloch, das in dem Flansch definiert ist, wobei das zumindest eine Luftloch mit dem Schlitz in Verbindung steht, wodurch ermöglicht wird, dass Luft aus dem Schlitz entweicht.

17. Elektronische Vorrichtung nach Anspruch 16, wobei zwei Klebstoffeinspritzlöcher und zwei Luftlöcher vorhanden sind; wobei die Klebstoffeinspritzlöcher jeweils in der Nähe von gegenüberliegenden Ecken des Fensters definiert sind und die Luftlöcher jeweils in der Nähe von den anderen gegenüberliegenden Ecken des Fensters definiert sind.

18. Elektronische Vorrichtung nach Anspruch 16, wobei das zumindest eine Klebstoffeinspritzloch im Wesentlichen kreisförmig ist und einen Durchmesser in dem Bereich von etwa 0,5 Millimeter bis etwa 1,0 Millimeter aufweist.

19. Elektronische Vorrichtung nach Anspruch 16, wobei das zumindest eine Luftloch im Wesentlichen kreisförmig ist und einen Durchmesser von etwa 0,5 Millimeter aufweist.

20. Elektronische Vorrichtung nach einem der Ansprüche 12 bis 19, wobei das Schutzgitter eine äußere Oberfläche und eine periphere Oberfläche umfasst und der Schlitz zwischen der peripheren Oberfläche und dem Hauptkörper in dem Aufnahmeraum definiert ist.

## Revendications

1. Boîtier comprenant :
un corps principal définissant une fenêtre à l'intérieur de celui-ci ;
une grille de protection couvrant la fenêtre pour définir une fente entre le corps principal et la grille de protection ; et
une couche de colle située dans la fente pour faire adhérer la grille de protection au corps principal ; **caractérisé en ce que**
le corps principal définit en outre un orifice d'injection de colle à proximité de la fenêtre ; et
dans lequel l'au moins un orifice d'injection de colle communique avec la fenêtre, et la couche de colle est formée en injectant de la colle dans la fente depuis chaque orifice d'injection de colle.

2. Boîtier selon la revendication 1, dans lequel la fenêtre est définie dans une surface interne du corps principal, le corps principal comprend en outre un espace de réception défini dans une surface externe de celui-ci, et la grille de protection est reçue dans l'espace de réception.

3. Boîtier selon la revendication 2, dans lequel la fenêtre communique avec l'espace de réception ; l'espace de réception est plus large que la fenêtre, formant ainsi une bride dans le corps principal autour de la fenêtre; la bride supportant la grille de protection lorsque la grille de protection est reçue dans l'espace de réception.

4. Boîtier selon la revendication 3, dans lequel l'au moins un orifice d'injection de colle est défini dans la bride.

5. Boîtier selon la revendication 4, comprenant en outre au moins un orifice d'air défini dans la bride, l'au moins un orifice d'air communiquant avec la fente permettant ainsi à l'air de s'échapper depuis la fente.

6. Boîtier selon la revendication 5, dans lequel il y a deux orifices d'injection de colle et deux orifices d'air ; les orifices d'injection de colle sont respectivement définis à proximité de coins opposés de la fenêtre et les orifices d'air sont respectivement définis à proximité des autres coins opposés de la fenêtre.

7. Boîtier selon la revendication 5, dans lequel l'au moins un orifice d'injection de colle est sensiblement circulaire et a un diamètre compris entre environ 0,5 millimètre et environ 1,0 millimètre.

8. Boîtier selon la revendication 5, dans lequel l'au moins un orifice d'air est sensiblement circulaire et a un diamètre d'environ 0,5 millimètre.

9. Boîtier selon l'une quelconque des revendications précédentes, dans lequel la grille de protection comprend une surface extérieure et une surface périphérique, et la fente est définie entre la surface périphérique et le corps principal dans l'espace de réception.

10. Boîtier selon la revendication 9, dans lequel la couche de colle est au même niveau que la surface externe du boîtier de telle sorte que la surface externe du boîtier est lisse.

11. Boîtier selon l'une quelconque des revendications précédentes, dans lequel la colle est une colle à séchage UV ou une colle thermodurcissable.

12. Dispositif électronique, comprenant :
un boîtier selon la revendication 1.

13. Dispositif électronique selon la revendication 12, dans lequel la fenêtre est définie dans une surface interne du corps principal, le corps principal comprend en outre un espace de réception défini dans une surface externe de celui-ci, et la grille de protection est reçue dans l'espace de réception.

14. Dispositif électronique selon la revendication 13, dans lequel la fenêtre communique avec l'espace de réception, et l'espace de réception est plus large que la fenêtre, formant ainsi une bride dans le corps principal autour de la fenêtre; la bride supportant la grille de protection lorsque la grille de protection est reçue dans l'espace de réception.

15. Dispositif électronique selon la revendication 14, dans lequel l'au moins un orifice d'injection de colle est défini dans la bride.

16. Dispositif électronique selon la revendication 15, comprenant en autre au moins un orifice d'air défini dans la bride, l'au moins un orifice d'air communiquant avec la fente, permettant ainsi à l'air de s'échapper depuis la fente.

17. Dispositif électronique selon la revendication 16, dans lequel il y a deux orifices d'injection de colle et deux orifices d'air; les orifices d'injection de colle sont respectivement définis à proximité de coins opposés à proximité de la fenêtre et les orifices d'air sont respectivement définis à proximité des autres coins opposés de la fenêtre.

18. Dispositif électronique selon la revendication 16, dans lequel l'au moins un orifice d'injection de colle est sensiblement circulaire et a un diamètre compris entre environ 0,5 millimètre et environ 1,0 millimètre.

19. Dispositif électronique selon la revendication 16, dans lequel l'au moins un orifice d'air est sensiblement circulaire et a un diamètre d'environ 0,5 millimètre.

20. Dispositif électronique selon l'une quelconque des revendications 12 à 19, dans lequel la grille de protection comprend une surface extérieure et une surface périphérique, et la fente est définie entre la surface périphérique et le corps principal dans l'espace de réception.
